## Europäisches Patentamt

## European Patent Office

## Office européen des brevets

(11) Publication number: **0 169 694**
**B1**

# EUROPEAN PATENT SPECIFICATION

(45) Date of publication of patent specification: **05.09.90**

(51) Int. Cl.⁵: **H 05 K 9/00**

(21) Application number: **85304990.6**

(22) Date of filing: **12.07.85**

(54) Component providing high frequency signal suppression.

(30) Priority: **25.07.84 US 634330**

(43) Date of publication of application:
**29.01.86 Bulletin 86/05**

(45) Publication of the grant of the patent:
**05.09.90 Bulletin 90/36**

(84) Designated Contracting States:
**AT DE FR GB IT**

(56) References cited:
**EP-A-0 013 364**
**DE-B-2 524 300**
**US-A-3 781 724**

(73) Proprietor: **RCA LICENSING CORPORATION**
**2 Independence Way**
**Princeton New Jersey 08540 (US)**

(72) Inventor: **Hettiger, James**
**8912 North Manderley Drive**
**Indianapolis Indiana (US)**

(74) Representative: **Smith, Thomas Ian Macdonald**
**RCA International Limited Burdett House 15-16**
**Buckingham Street**
**London WC2N 6DU (GB)**

Courier Press, Leamington Spa, England.

## Description

This invention relates to components used in the suppression of high frequency signals and, in particular, to suppression of high frequency signals through the use of ferrite components.

Various sorts of circuits, such as tuning and video signal processing circuits used in television receivers, computer monitors and video tape recorders, for example, require careful design to prevent undesirable signal interference. The presence of high frequency, e.g. radio frequency (rf), signal energy may interact with stray circuit capacitance and lead inductance in circuits having high frequency field effect transistors, for example, to create high frequency signal oscillations that may disrupt circuit operation. Radio frequency energy may also be coupled from one circuit to another via exposed component leads, also causing undesirable circuit operation.

A solution to the problem of uncontrolled rf energy involves the use of ferrite beads located on critical component or conductor leads. The ferrite beads, typically in the shape of a ring or cylinder, act as rf chokes and attenuate the rf or high frequency current flowing in their associated leads or conductors. The ferrite beads present very little impedance at dc or low signal frequencies but present an increasing impedance as the signal frequency increases. Different ferrite compositions exhibit different impedance-frequency characteristics, which are described by the ferrite manufacturer.

US-A-3781724 discloses a terminal block having electrically conductive pins extending through bores in tubular pieces of ferrite material acting as rf filters. DE-A-2524300 discloses an annular ferrite microwave absorber within a coaxial conductor.

The requirement for a ferrite bead at a particular circuit location is often not shown until the circuit is constructed and tested. When a need for a ferrite bead is determined, it is often necessary to place the bead on the component lead or conductor by hand, thereby increasing the circuit manufacturing time and cost.

There is an increasing utilization of leadless chip components by circuit designers in order to reduce circuit size requirements. These leadless chips are typically small, thin, flat components which are applied to the conductor side of a printed circuit board by insertion machines. The chips are held in place on the board by an adhesive, such as epoxy. Edges of the chip may comprise the component electrical terminals. Electrical contact between the chip terminals and the circuit board is via solder bridge typically applied by a wave or reflow soldering apparatus.

Leadless chip components are particularly useful in the design of tuning circuits for video equipment, such as television receivers, computer monitors and video cassette recorders. The undesirable transfer of rf energy via exposed leads between conventional leaded components can be better controlled through the use of leadless chip components. This may in turn permit accurate predictions as to the locations where ferrite beads are necessary, thus reducing circuit design and testing time. The placement of the ferrite bead in the circuit, however, would still be required to be done by hand or by conventional axial leaded component insertion techniques.

In accordance with the present invention, there is provided a ferrite component for application to an electrical printed circuit board said ferrite component comprising electrical conductor means and magnetically permeable ferrite shield means substantially surrounding said electrical conductor means characterized in that the component is a leadless component for surface mounting on the said board and includes first and second leadless contact terminals, said first and second leadless contact terminals of said conductor means being accessible for providing electrical contact with said conductor means.

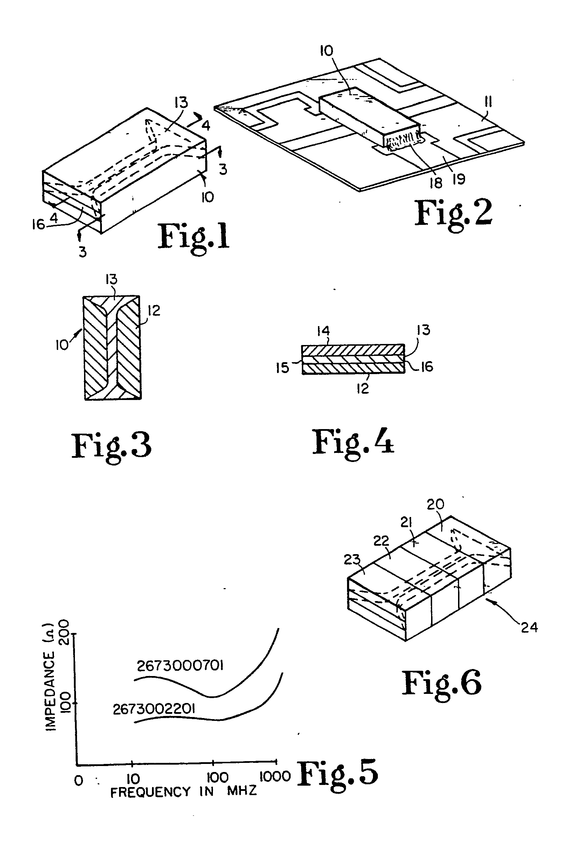

In the accompanying drawing, FIGURE 1 is an isometric schematic view of an electrical component in accordance with an aspect of the present invention;

FIGURE 2 is an isometric view of the electrical components shown in FIGURE 1, illustrating a representative mounting arrangement;

FIGURE 3 is a top cross-sectional view of the electrical component shown in FIGURE 1, taken along line 3-3.

FIGURE 4 is a side elevational cross-sectional view of the electrical component shown in FIGURE 1, taken along line 4-4;

FIGURE 5 is a graph illustrating a representative electrical characteristic of a component similar to that shown in FIGURE 1;

FIGURE 6 is an isometric schematic view of an electrical component illustrating another aspect of the present invention;

FIGURE 7a is an isometric schematic view of an electrical component illustrating another aspect of the present invention;

FIGURE 7b is a top cross-sectional view of the electrical component shown in FIGURE 7a, taken along line 7-7;

FIGURE 8 is a schematic diagram of a circuit incorporating an electrical component similar to that shown in FIGURES 1, 6 or 7a; and

FIGURE 9 is a top plan view of a circuit board incorporating components forming the circuit shown in FIGURE 8.

Referring to FIGURE 1, there is shown an electrical component 10 that provides rf or high frequency signal suppression similar to that of a conventional ferrite bead, but is in the form of a surface mounted or leadless chip component. In FIGURE 2, component 10 is shown mounted in place on a printed circuit board 11. Component 10 is applied to the conductor or foil side of circuit board 11 by commercially available leadless chip insertion machines of known construction and held in place by epoxy using conventional chip epoxying techniques. Electrical connection to the circuit board is via conventional reflow or wave soldering techniques, which forms a solder bridge connection 18 with the foil conductor 19.

As shown in FIGURES 3 and 4, component 10 comprises a first layer of ferrite material 12. A layer of conductor material 13 may be vapor deposited onto the ferrite layer 12. A second layer 14 of ferrite material may be compressed onto the first layer 12 and conductor layer 13. Conductor 13 will therefore be encompassed or surrounded by ferrite material, except for a surface 15 and a surface 16 located at opposite ends of component 10 which form leadless contacts that permit electrical access to conductor 13 via a solder bridge connection 18 such as is shown in FIGURE 2. Conductor 13 may also be formed as a conductor sheet or wire, with the ferrite material being molded and cured around the conductor. Other means by which ferrite material can be made to substantially surround a length of conductor material are of course possible. At high frequencies, above several hundred megahertz, for example, it becomes quite important to have close contact between the ferrite material and the conductor, since the skin effect causes all conductor current flow to occur within a few thousandths of an inch of the conductor surface. The ferrite material is, therefore, most effective if it is in close contact with the electrical conductor. A technique to accomplish this would have the conductor material vapor deposited onto and sandwiched between two slabs of ferrite material.

A possible method for forming a quantity of ferrite shield chip components may comprise forming a thin sheet of ferrite material onto a flat surface. A conductor pattern would then be vapor deposited onto the ferrite layer. A second ferrite layer would then be placed onto the first ferrite layer and conductor layer. The ferrite would then be cured. The completed material would then be machined be otherwise separated into individual ferrite chip components.

The circuit impedance provided by a given type of ferrite material for a representative component 10 is in part determined by the frequency of the current flowing through conductor 13. With dc or low frequency signals, the impedance provided by components 10 is very small or negligible. As current flows through conductor 13, it creates a magnetic field. As the signal frequency increases, the permeability of the ferrite material increases, causing a greater portion of the magnetic field to pass through the ferrite material. This raises the circuit impedance in the vicinity of component 10, effectively suppressing undesirable high frequency signals. A typical impedance versus signal frequency response curve is shown in FIGURE 5 for two different ferrite materials manufactured by Fair-Rite Products Corp. of Wallkill, N.Y., and identified in FIGURE 5. As can be seen in FIGURE 5, the type of ferrite material can influence the circuit impedance at a given frequency. It is possible to produce a particular impedance versus frequency response characteristic by forming the ferrite shield component from a plurality of different ferrite materials. As shown in FIGURE 6, shield elements 20, 21, 22 and 23, disposed along the longitudinal conductor signal path comprise the complete ferrite shield component 24. Each shield element may comprise a different type of ferrite material having different impedance-frequency characteristics. Each shield element will contribute to the overall impedance-frequency characteristic so that it is possible to design a circuit component having virtually any desired impedance-frequency characteristic.

The impedance presented by the ferrite shield component is also determined by the amount of ferrite material and, in particular, by the conductor path length through the ferrite material. In applications using conventional tubular ferrite beads, it is often necessary to use two or more beads in series to provide the desired signal attenuation.

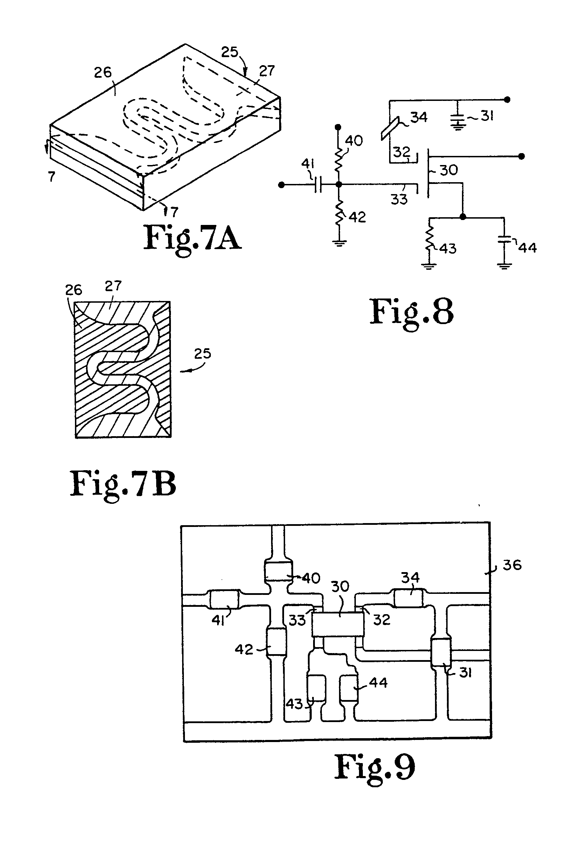

It is of course possible to utilize two or more ferrite shield components, such as component 10, to provide additional signal attenuation. However, this reduces the advantages provided by the small size of the components. FIGURE 7 illustrates a means by which a single component can provide signal attenuation otherwise requiring two or more components. A ferrite shield component 25 comprises ferrite material 26 surrounding a conductor 27. Conductor 27 is formed in a circuitous path, which increases the signal path length through the ferrite material 26 and thereby increases the circuit impedance and consequently the amount of signal attenuation.

FIGURE 8 illustrates a schematic diagram of a portion of an electrical circuit, incorporating a dual gate MOSFET 30, illustratively used as an rf amplifier in a television receiver tuner, such as that found in the CTC-121 Color Television Chassis, manufactured by RCA Corporation. A capacitor 31 provides a high frequency path to ground to prevent feedback from gate 32 to gate 33 which could disrupt the operation of MOSFET 30. Capacitor 31 may, however, form a high frequency oscillator with the inductance of the conductor leading to gate 32. In order to suppress these oscillations, a ferrite shield component 34 is placed on the gate 32 conductor. The use of a shield component such as is shown in FIGURES 1, 6 or 7a allows the placement of component 34 close to the gate 32 terminal, particularly important in tuning circuits in order to eliminate rf coupling via component leads. The use of ferrite chip component 34 results in efficient use of space on the circuit board. Component 34 may be placed via an automatic insertion machine, which is faster and more efficient than placement by hand. Manual placement was previously required since an axial component insertion machine could not place a component close enough to MOSFET 30 to effectively suppress the high frequency signals. FIGURE 9 illustratively shows MOSFET 30, capacitor 31, and ferrite shield component 34 as surface mounted components in place on a circuit board 36. Corresponding components in FIGURE 8 and 9 are designated using the same reference numerals.

It is also desirable in some circumstances to place ferrite beads on the leads of bipolar transistors to suppress high frequency oscillations. The use of leadless transistor chips makes this impossible, however. The use of ferrite beads having axial conductor leads does not allow the placement of the ferrite bead close enough to the transistor to efficiently utilize circuit board space. The use of a ferrite shield component such as shown in FIGURES 1, 6 or 7a permits the desirable close spacing between the transistor and the ferrite shield component while enabling the efficient utilization of similar component insertion equipment and technology.

## Claims

1. A ferrite component (10) for application to an electrical printed circuit board (11) said ferrite component comprising electrical conductor means (13) and magnetically permeable ferrite shield means (12, 14) substantially surrounding said electrical conductor means (13) characterized in that the component is a leadless component for surface mounting on the said board and includes first (15) and second (16) leadless contact terminals, said first and second leadless contact terminals of said conductor means being accessible for providing electrical contact with said conductor means.

2. A component according to Claim 1, wherein the component is generally in the form of a rectangular parallelepiped, (10), said electrical conductor means being accessible as said leadless contact terminals (15, 16) at opposite ends of said rectangular parallelepiped.

3. A component according to Claim 2, wherein said electrical conductor means (13) defines a substantially direct path through said ferrite shield means (Fig. 3).

4. A component according to Claim 2, wherein said electrical conductor means (27) defines a circuitous path through said ferrite shield means (Fig. 7).

5. A component according to Claim 2, 3 or 4 wherein said ferrite shield means comprises a plurality of different ferrite materials defining distinct zones (20, 21, 22, 23) each of said zones exhibiting different electrical frequency-impedance characteristics (Fig. 6).

6. A component according to any one of claims 1 to 5, in combination with an electrical printed circuit board (11) which comprises an electrically conductive foil pattern (19) and wherein electrically conductive solder bridges (18) are formed between said first and second leadless contact terminals (15, 16) and respective areas of said electrically conductive foil pattern.

7. An electrical circuit comprising:
a printed circuit board (11); and
a plurality of surface mounted chip components (31, 40, 41, 42, 43) mounted on said printed circuit board; and characterized by a surface mounted ferrite component (34) according to any one of Claims 1 to 6 mounted adjacent to and electrically coupled to an electrical terminal (32) of one of said chip components (30) for high frequency signal suppression.

8. A circuit according to Claim 7, wherein said one of the chip components is a transistor (30).

## Patentansprüche

1. Ferritbauteil (10) zum Anbringen an einer elektrischen Gedruckte-Schaltung-Platine (11), welches eine elektrische Leiteranordnung (13) und eine magnetisch permeable Ferritabschirmungsanordnung (12, 14) aufweist, die die elektrische Leiteranordnung (13) im wesentlichen umgibt, dadurch gekennzeichnet, daß das Bauteil ein anschlußdrahtloses Bauteil zur Oberflächenmontage auf der Platine ist und einen ersten (15) sowie einen zweiten (16) anschlußdrahtlosen Anschlußkontakt aufweist, welche zugänglich sind, um einen elektrischen Kontakt mit der Leiteranordnung herzustellen.

2. Bauteil nach Anspruch 1, welches im wesentlichen die Form eines rechteckigen Parallelepipeds (10) hat, wobei die elektrische Leiteranordnung zugänglich ist wie die anschlußdrahtlosen Anschlußkontakte (15, 16) an entgegengesetzten Enden des rechteckigen Parallelepipeds.

3. Bauteil nach Anspruch 2, bei welchem die elektrische Leiteranordnung (13) einen im wesentlichen direkten Weg durch die Ferritabschirmungsanordnung bildet (Figur 3).

4. Bauteil nach Anspruch 2, bei welchem die elektrische Leiteranordnung (27) einen gewundenen Weg durch die Ferritabschirmungsanordnung bildet (Figur 7).

5. Bauteil nach Anspruch 2, 3 oder 4, bei welchem die Ferritabschirmungsanordnung eine Mehrzahl verschiedener Ferritmaterialien enthält, die unterschiedliche Zonen (20, 21, 22, 23) bilden, welche jeweils verschiedene elektrische Frequenz Impedanz-Charakteristiken aufweisen (Figur 6).

6. Bauteil nach einem der Ansprüche 1 bis 5 in Kombination mit einer elektrischen Gedruckte-Schaltung-Platine (11), die ein elektrisch leitfähiges Folienmuster (19) aufweist und bei der elektrisch leitfähige Lotbrücken (18) zwischen dem ersten sowie dem zweiten anschlußdrahtlosen Anschlußkontakt (15, 16) und entsprechenden Bereichen des elektrisch leitfähigen Folienmusters gebildet sind.

7. Elektrische Schaltung mit
einer Gedruckte-Schaltung-Platine (11); und
einer Mehrzahl von oberflächenmontierten Chip-Bauteilen (31, 40, 41, 42, 43), die auf der Gedruckte-Schaltung-Platine montiert sind, gekennzeichnet durch ein oberflächenmontiertes Ferritbauteil (34) gemäß einem der Ansprüche 1 bis 6, welches zur Hochfrequenzsignalunterdrückung neben einem elektrischen Anschluß (32) einer der Chip-Komponenten (30) montiert und mit diesem elektrisch gekoppelt ist.

8. Schaltung nach Anspruch 7, bei der die erwähnte eine Chip-Komponente ein Transistor (30) ist.

## Revendications

1. Composant en ferrite (10) pour application à une planche de circuit imprimé électrique (11), ledit composant en ferrite comprenant un moyen conducteur électrique (13) et un moyen de blindage en ferrite magnétiquement perméable (12, 14) entourant sensiblement ledit moyen conducteur électrique (13), caractérisé en ce que le composant est un composant sans fil pour un montage en surface sur ladite planche et comporte des première (15) et seconde (16) bornes de contact sans fil, lesdites première et seconde bornes de contact sans fil dudit moyen conducteur étant accessibles pour permettre un contact électrique avec ledit moyen conducteur.

2. Composant selon la revendication 1, où le composant a généralement la forme d'un parallélépipède rectangle (10), ledit moyen conducteur électrique étant accessible en tant que lesdites bornes de contact sans fil (15, 16) aux extrémités opposées dudit parallélépipède rectangle.

3. Composant selon la revendication 2, où ledit moyen conducteur électrique (13) définit un trajet sensiblement direct à travers le moyen de blindage en ferrite (Figure 3).

4. Composant selon la revendication 2, où ledit moyen conducteur électrique (27) définit un trajet tortueux à travers ledit moyen de blindage en ferrite (Figure 7).

5. Composant selon la revendication 2, 3 ou 4, où ledit moyen de blindage en ferrite comprend un certain nombre de matériaux différents de ferrite définissant des zones distinctes (20, 21, 22, 23), chacunedesdites zones présentant des caractéristiques différentes fréquence électrique-impédance (Figure 6).

6. Composant selon l'une quelconque des revendications 1 à 5, en combinaison avec une planche de circuit imprimé électrique (11), qui comprend un schéma en feuille électriquement conducteur (19) et où des ponts électriquement conducteurs de soudure (18) sont formés entre lesdites première et seconde bornes de contact sans fil (15, 16) et des zones respectives dudit schéma en feuille électriquement conducteur.

7. Circuit électrique comprenant:
une planche de circuit imprimé (11); et
un certain nombre de composants sur pastille montés en surface (31, 40, 41, 42, 43), montés sur ladite planche de circuit imprimé; et caractérisé par un composant de ferrite monté en surface (34) selon l'une quelconque des revendications 1 à 6, monté adjacent à et électriquement couplé à une borne électrique (32) de l'un desdits composants (30) sur pastille pour une suppression des signaux à haute fréquence.

8. Circuit selon la revendication 7, où ledit composant sur pastille est un transistor (30).

Fig.1

Fig.2

Fig.3

Fig.4

Fig.5

Fig.6

IMPEDANCE (Ω)

2673000701

2673002201

FREQUENCY IN MHZ

Fig.7A

Fig.7B

Fig.8

Fig.9